(19) Europäisches Patentamt
European Patent Office
Office européen des brevets

(11) Veröffentlichungsnummer : **0 038 476**
**B1**

(12) **EUROPÄISCHE PATENTSCHRIFT**

(45) Veröffentlichungstag der Patentschrift : **04.07.84**

(21) Anmeldenummer : **81102690.5**

(22) Anmeldetag : **09.04.81**

(51) Int. Cl.³ : **G 03 F 7/10**, B 41 N 1/00, G 03 C 1/68

# (54) Zur Herstellung von Druck- und Reliefformen geeignete Mehrschichtelemente.

(30) Priorität : **22.04.80 DE 3015340**

(43) Veröffentlichungstag der Anmeldung : **28.10.81 Patentblatt 81/43**

(45) Bekanntmachung des Hinweises auf die Patenterteilung : **04.07.84 Patentblatt 84/27**

(84) Benannte Vertragsstaaten : **BE CH DE FR GB IT LI NL**

(56) Entgegenhaltungen : **EP-A- 0 005 750**

(73) Patentinhaber : **BASF Aktiengesellschaft**
**Carl-Bosch-Strasse 38**
**D-6700 Ludwigshafen (DE)**

(72) Erfinder : **Hartmann, Heinrich, Dr.**
**Weinheimer Strasse 46**
**D-6703 Limburgerhof (DE)**
Erfinder : **Hoffmann, Gerhard, Dr.**
**Pappelstrasse 22**
**D-6701 Otterstadt (DE)**
Erfinder : **Lenz, Werner, Dr.**
**Heinrich-Baermann-Strasse 14**
**D-6702 Bad Duerkheim (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 038 476 B1

Jouve, 18, rue St-Denis, 75001 Paris, France

## Beschreibung

Die Erfindung betrifft zur Herstellung von Druck- und Reliefformen geeignete Mehrschichtelemente, die eine verbesserte Stabilität bei der Verarbeitung, insbesondere bei der Trocknung und Nachbelichtung aufweisen.

Mit Wasser oder wäßrigen Lösungen entwickelbare Mehrschichtelemente für die Herstellung von photopolymeren Druck- und Reliefformen sind an sich bekannt und vielfach beschrieben (vgl. z. B. GB-PS 834 337 oder US-PS 3 877 939). Bei der Verarbeitung solcher wasserentwickelbarer photopolymerer Druck- und Reliefplatten beobachtet man bei der Nachbehandlung der Druck- und Reliefformen, das sind vor allem die Trocknung und Nachbelichtung, Trocknungsschäden der Klischees in Form von Ablösungen der Photopolymerschicht von der Trägerplatte. Diese, insbesondere bei der Trocknung mit Infrarotstrahlen auftretenden Trocknungsschäden treten in allen Reliefelementen auf, also in Volltönen, Rasterfeldern, Linien und Punkten. Diese Trocknungsschäden werden schon bei Nachbehandlungs- und Trocknungsbedingungen erhalten, bei denen noch keine ausreichende Härtung des Reliefs erreicht wird. D. h., um eine geforderte Qualität dieser Photopolymerschichten zu gewährleisten, müßten die Nachbehandlungsbedingungen in bezug auf Temperatur, Trocknungsdauer und Strahlungsleistung verschärft werden. Durch die Trocknungsschäden werden die Platten weitgehend unbrauchbar. Mit Platten, die unter milderen Bedingungen ohne solche Schäden produziert werden, kann keine gute Druckqualität und keine hohe Druckleistung erwartet werden.

Aus der EP-A-5750 sind photopolymerisierbare Gemische bekannt, die neben einem alkalilöslichen Bindemittel und Photoinitiatoren als Monomere spezielle Polyurethane mit zwei endständigen Acrylat- oder Methacrylat-Gruppen enthalten. Diese photopolymerisierbaren Gemische eignen sich insbesondere zur Herstellung von Photoresistschichten und Trockenfilmresisten und sollen einen verminderten kalten Fluß, eine verminderte Sprödigkeit im unbelichteten und belichteten Zustand sowie auch eine gute Haftung auf metallischen Untergründen, z. B. Kupfer, wie sie bei der Herstellung von Photoresisten Anwendung finden, aufweisen. Auf die Herstellung von Haftschichten für Mehrschichtenelemente, die für die Herstellung von Druck- und Reliefformen geeignet sind, findet sich in dieser Schrift kein Hinweis.

Der vorliegenden Erfindung lag die Aufgabe zugrunde, bei mit Wasser oder mit wäßrigen Lösungen entwickelbaren photopolymeren Elementen, deren photoempfindliche Schicht mindestens ein hydrophiles polymeres Bindemittel enthält, das Auftreten solcher insbesondere bei der Trocknung mit Infrarotstrahlen auftretenden Trocknungsschäden zu verhindern, auch bei für gute Platteneigenschaften erforderlichen verschärften Nachbehandlungsbedingungen.

Es wurde nun gefunden, daß zur Herstellung von Druck- und Reliefformen geeignete Mehrschichtelemente mit

(a) einer photoempfindlichen Schicht einer in Wasser oder in wäßriger Lösung löslichen Mischung von

(a1) mindestens einem hydrophilen polymeren Bindemittel mit

(a2) mindestens einem damit verträglichen photopolymerisierbaren ethylenisch ungesättigten Monomeren sowie

(a3) einem durch aktinisches Licht aktivierbaren Fotoinitiator,

(b) einer dimensionsstabilen Trägerschicht und

(c) einer dünnen Zwischenschicht zwischen den Schichten (a) und (b), die gebildet wird aus einer Mischung enthaltend

(c1) mindestens ein mit dem polymeren Bindemittel (a1) der Schicht (a) verträgliches polymeres Bindemittel,

(c2) mindestens ein damit verträgliches photopolymerisierbares ethylenisch ungesättigtes Monomeres und

(c3) ggf. einen durch aktinisches Licht aktivierbaren Fotoinitiator,

die gewünschten Eigenschaften weitgehend aufweisen, wenn die die Zwischenschicht (c) bildende Mischung ein Monomeres

(c2') der Struktur

$$\begin{array}{l} CH_2{=}CR^1{-}COO{-}({-}CH_2{-}CHR^3{-}O{-})_m{-}CO{-}NH \\ \hspace{14em} | \\ \hspace{14em} X \\ \hspace{14em} | \\ CH_2{=}CR^2{-}COO{-}(CH_2{-}CHR^4{-}O)_n{-}CO{-}NH \end{array}$$

enthält, worin bedeuten

$R^1$, $R^2$, $R^3$, $R^4$ = jeweils für sich, ein H-Atom oder eine $C_1$-$C_8$-Alkylgruppe, wobei die Reste $R^1$ bis $R^4$ gleich oder verschieden sein können,

X = $C_2$-$C_7$-Alkylenrest, 2-wertiger aromatischer $C_6$-$C_{10}$-Kohlenwasserstoffrest oder Isophoronylen-Rest

n, m = voneinander unabhängige Zahlen von 1 bis 4, und die Zwischenschicht (c) nach Auftrag auf

die Trägerschicht bei einer Temperatur zwischen 110 und 220 °C getrocknet wurde.

Die Verwendung von Mehrschichtelementen mit den erfindungsgemäßen Zwischenschichten für bildmäßige Belichtungen mit aktinischem Licht und anschließendes Auswaschen der unbelichteten Bereiche erlaubt die Herstellung von Druck- und Reliefplatten, die bei der Nachbehandlung keine Trocknungsschäden der Klischees aufweisen.

Als photoempfindliche Schicht (a) einer in Wasser oder wäßriger Lösung löslichen Mischung von (a1) mindestens einem hydrophilen polymeren Bindemittel mit (a2) mindestens einem damit verträglichen photopolymerisierbaren ethylenisch ungesättigten Monomeren und (a3) einem Fotoinitiator kommen beispielsweise Mischungen in Frage, wie sie z. B. in den brit. Patentschriften 786 199, 834 337, 835 849, 1 233 883, 1 351 475 oder 1 416 440 beschrieben sind, auf deren Offenbarung diesbezüglich ausdrücklich Bezug genommen wird, wobei als hydrophile polymere Bindemittel (A1) wasserlösliche Polyvinylalkohole und dessen wasserentwickelbare Copolymere und Derivate wie dessen Ester, Ether oder Acetale bevorzugt sind. Als Monomere (a2) haben sich Hydroxylgruppen enthaltende (Meth)Acrylate, wie Hydroxyethyl(meth)-acrylat, sowie Mono- und Di(meth)acrylate von aliphatischen Glykolen, wie z. B. Mono- und Di(meth)acrylate von Ethylenglykol, Butandiol-1,4, Diethylenglykol und Polyethylenglykolen mit Molekulargewichten bis ca. 500, besonders bewährt.

Als polymere Bindemittel (c1) für die Zwischenschicht (c) kommen solche in Frage, die mit dem polymeren Bindemittel der Schicht (a) verträglich sind, bevorzugt sind Polyvinylalkohol, Vinylalkohol-Copolymere und deren wasser-entwickelbaren Derivate insbesondere des Typs, wie sie auch als polymere Bindemittel in der photoempfindlichen Schicht (a) enthalten sein können.

Die die Zwischenschicht (c) bildende Mischung enthält erfindungsgemäß, bevorzugt in einer Menge von 1 bis 25 Gew.-%, bezogen auf die Summe der Mengen von (c1) und (c2), ein Monomeres (c2') der oben angegebenen Formel. Vorzugsweise stellen in dieser Formel die Reste $R^1$ bis $R^4$ ein Wasserstoffatom eine Methyl-, Ethyl-, Propyl- oder Butyl-Gruppe, insbesondere ein Wasserstoff-Atom, eine Methyl- oder Ethyl-Gruppe dar. X ist in dieser Formel insbesondere der Hexamethylen-, Toluylen- oder Isophoronylen-Rest. Bevorzugte Monomere dieser Art sind Umsetzungsprodukte von 2 Molen von β-Hydroxyethyl- oder β-Hydroxypropylacrylat oder -methacrylat mit 1 Mol Hexamethylendisiocyanat, Toluylendiisocyanat oder Isophorondiisocyanat, doch sind auch z. B. die Umsetzungsprodukte von Diäthylenglykol- oder Triäthylenglykolmonoacrylat oder -monomethacrylat mit entsprechenden Diisocyanaten geeignet.

Sofern der Zwischenschicht (c) ein Photoinitiator zugesetzt wird, beträgt dessen Menge 0,1 bis 10 Gew.-% und bevorzugt 0,5 bis 5 Gew.-%, bezogen auf die Gesamtmenge der Komponenten der Zwischenschicht (c). Als Photoinitiatoren kommen dabei alle bekannten und gebräuchlichen Photoinitiatoren in Betracht.

Die die Zwischenschicht (c) bildende Mischung wird nach bekannten Verfahren schichtförmig auf die dimensionsstabile Trägerschicht (b) so aufgebracht, daß die Stärke der Zwischenschicht (c) nach dem Einbrennen bzw. Trocknen bei 110 bis 220 °C und insbesondere bei 140 bis 170 °C, zweckmäßigerweise 5 bis 10 μm beträgt, wobei die bevorzugte Einbrennzeit bei 3 bis 10 Minuten liegt.

Als dimensionsstabile Trägerschichten (b) kommen vor allem die für die Herstellung von Relief- und Druckplatten üblichen metallischen Unterlagen, wie Stahl- oder Aluminiumbleche in Frage, die in an sich bekannter Art mechanisch, chemisch oder durch Versehen mit einer Haftgrundierung vorbehandelt sein können. Gut bewährt haben sich Stahlbleche, die mit einem Haftgrundlack, wie er in der DE-OS 15 97 515 beschrieben ist, in einer Schichtstärke von 10 bis 40 μm und insbesonder 15 bis 25 μm beschichtet wurden.

Auf die photoempfindliche Schicht (a) der erfindungsgemäßen Mehrschichtelemente kann gegebenenfalls noch in bekannter Weise eine abziehbare Schutz- oder Deckfolie, beispielsweise aus Polyester, aufgebracht sein.

Die in dem folgenden Beispiel und Vergleichsversuchen genannten Teile und Prozente beziehen sich, soweit nicht anders angegeben, auf das Gewicht. Teile verhalten sich zu Volumenteilen wie Kilogramm zu Liter.

## Beispiel 1

1.1 Es wird eine Lösung hergestellt aus 44 % Wasser, 44 % Methanol, 11,04 % eines teilweise verseiften Polyvinylacetats (Verseifungsgrad von 82 Mol.-%, Durchschnittsmolekulargewicht 25 000), 0,72 % eines Reaktionsproduktes aus 1 Mol Toluylendiisocyanat mit 2 Molen β-Hydroxyäthylmethacrylat als Monomeres (c2') und 0,24 % Benzoinäthyläther. Die Lösung wird auf ein mit einem Polyurethan-Grundierlack gemäß DE-OS 15 97 515 (hergestellt aus einem handelüblichen hydroxylgruppenhaltigen Polyester aus 2,5 Mol Adipinsäure, 0,5 Mol Phthalsäure und 4 Mol 1,1,1-Trimethylolpropan durch Umsetzung mit einem durch Reaktion von 3 Molen Toluylendiisocyanat mit 1 Mol 1,1,1-Trimethylolpropan hergestellten Triisocyanat) vorbehandelten Stahlblech in einer solchen Stärke aufgetragen, daß nach 7-minütigem Trocknen bei 150 °C in einem Trockenschrank eine Zwischenschicht (c) mit einer Schichtstärke von 10 μm resultiert.

1.2 Für die Herstellung der photoempfindlichen Schicht (a) werden 294 Teile eines teilweise verseiften Polyvinylacetats (Verseifungsgrad 82 Mol.-%, Durchschnittsmolekulargewicht 25 000) durch

mehrstündiges Rühren in 294 Teilen Wasser bei 90 °C gelöst. Nach Abkühlen auf 70 °C werden unter Rühren 200 Teile eines Gemisches aus 180 Teilen 2-Hydroxyäthylmethacrylat, 20 Teilen 1,1,1-Trimethylolpropantriacrylat, 10 Teilen Benzildimethylketal und 2 Teilen 2,6-Di-tert.-butyl-p-kresol zugegeben. Die homogene, viskose Lösung wird filtriert und unter reduziertem Druck entgast. Sie wird auf eine (später als Deckschicht wirkende) 125 µm starke Polyesterfolie schichtförmig so aufgetragen, daß nach 24-stündigem Trocknen bei Raumtemperatur eine 550 µm starke nicht klebende Schicht (a) resultiert.

1.3 Nach Anfeuchten der Schicht (a) sowie der Zwischenschicht (c) mit einem Wasser-Methanol-Gemisch wird das gemäß 1.2 hergestellte Zweischichtenelement mit der photoempfindlichen Schicht (a) auf die Zwischenschicht (c) der gemäß 1.1 mit der Zwischenschicht (c) versehenen Stahlplatte aufkaschiert und die Polyesterdeckschicht abgezogen.

Das resultierende Mehrschichtelement wird bildmäßig mit aktinischen Licht belichtet. Mit Wasser werden dann die nichtbelichteten Anteile der Schichten (a) und (c) ausgewaschen und die resultierende Druckform wird danach in einer mit Infrarotheizstäben versehenen Nachbehandlungsvorrichtung 2,5 Minuten bei 90 °C (die vom Temperaturfühler in der Vorrichtung angezeigte Umlufttemperatur liegt unter der Temperatur der Druckformoberfläche) getrocknet und nachbelichtet.

Die so hergestellte Reliefform weist ein einwandfreies Relief auf und ist gut als Druckform zu verwenden.

### Vergleichsversuch A

Es wird exakt wie in Beispiel 1 angegeben verfahren, jedoch werden in der Lösung zur Herstellung der Zwischenschicht (c) statt des Reaktionsproduktes aus Toluylendiisocyanat und β-Hydroxyäthylmethacrylat 0,72 % β-Hydroxyäthylmethacrylat verwandt. Nach der Nachbehandlung der entwickelten Platte exakt gemäß Beispiel 1.3 ist die resultierende Reliefform stark zerstört und als Druckform für den Hochdruck nicht brauchbar.

### Vergleichsversuch B

Es wird exakt wie in Beispiel 1 angegeben verfahren, jedoch besteht der Feststoffgehalt für die Lösung zur Herstellung der Zwischenschicht (c) gemäß 1.1 aus 86 % des angegebenen Polyvinylalkohols, zu 12 % aus Tetraäthylenglykoldimethacrylat und zu 2 % aus Benzoinmethyläther. Die ansonsten exakt wie in Beispiel 1 angegebenen hergestellten und nachbehandelten Reliefformen weisen deutliche Beschädigungen der Reliefstruktur auf und sind als Druckform wenig brauchbar.

## Ansprüche

1. Zur Herstellung von Druck- und Reliefformen geeignete Mehrschichtelemente mit

(a) einer photoempfindlichen Schicht einer in Wasser oder wäßriger Lösung löslichen Mischung von

(a1) mindestens einem hydrophilen polymeren Bindemittel,

(a2) mindestens einem damit verträglichen photopolymerisierbaren ethylenisch ungesättigten Monomeren und

(a3) einem durch aktinisches Licht aktivierbaren Fotoinitiator ;

(b) einer dimensionsstabilen Trägerschicht und

(c) einer dünnen Zwischenschicht zwischen Schicht (a) und Schicht (b) mit einer Mischung von

(c1) mindestens einem mit dem polymeren Bindemittel (a1) der Schicht (a) verträglichen polymeren Bindemittel und

(c2) mindestens einem damit verträglichen photopolymerisierbaren ethylenisch ungesättigten Monomeren,

dadurch gekennzeichnet, daß die Zwischenschicht ein Monomeres (c2') der Struktur

$$\begin{array}{l} CH_2{=}CR^1{-}COO({-}CH_2{-}CHR^3{-}O)_m{-}CO{-}NH \\ \qquad\qquad\qquad\qquad\qquad\qquad\qquad\quad X \\ CH_2{=}CR^2{-}COO({-}CH_2{-}CHR^4{-}O)_n{-}CO{-}NH \end{array}$$

worin

$R^1$, $R^2$, $R^3$, $R^4$ = H oder $C_1$-$C_8$-Alkylrest, gleich oder verschieden

X = $C_2$-$C_7$-Alkylenrest, aromatischer $C_6$-$C_{10}$-Kohlenwasserstoffrest oder Isophoronylen-Rest

n, m = 1 bis 4, gleich oder verschieden, bedeuten, enthält und die Zwischenschicht nach Auftrag auf die Trägerschicht bei einer Temperatur von 110 bis 220 °C getrocknet wurde.

2. Mehrschichtelemente gemäß Anspruch 1, dadurch gekennzeichnet, daß das Monomere (c2') ein Umsetzungsprodukt aus 2 Molen β-Hydroxyäthyl- oder β-Hydroxypropylacrylat oder -methacrylat und 1 Mol Hexamethylendiisocyanat, Toluylendiisocyanat oder Isophorondiisocyanat darstellt.

3. Mehrschichtelemente gemäß den Ansprüchen 1 oder 2, dadurch gekennzeichnet, daß die Zwischenschicht das Monomere (c2') in einer Menge von 1 bis 25 Gew.% der Mischung von (c1) und (c2) aufweist.

4. Mehrschichtelemente gemäß den Ansprüchen 1 bis 3, dadurch gekennzeichnet, daß die Zwischenschicht (c) als polymeres Bindemittel (c1) ein wasserlösliches Vinyl-alkohol-Polymeres enthält.

5. Mehrschichtelemente gemäß einem der Ansprüche 1 bis 4, dadurch gekennzeichnet, daß die Zwischenschicht (c) eine Mischung von 75 bis 99 Gew.-% eines wasserlöslichen Vinylalkohol-Polymeren als polymeres Bindemittel (c1) und 1 bis 25 Gew.-% des Monomeren (c2') enthält.

6. Mehrschichtelemente gemäß einem der Ansprüche 1 bis 5, dadurch gekennzeichnet, daß die Trägerschicht (b) aus einer mechanisch, chemisch und/oder durch Versehen mit einer Haftgrundierung vorbehandelten metallischen Unterlage besteht.

## Claims

1. A laminate suitable for the production of printing plates and relief plates, comprising

(a) a photosensitive layer of a mixture, soluble in water or in an aqueous solution, of

($a_1$) at least one hydrophilic polymeric binder,

($a_2$) at least one photopolymerizable ethylenically unsaturated monomer compatible therewith, and

($a_3$) a photoinitiator which can be activated by actinic light,

(b) a dimensionally stable base, and

(c) a thin intermediate layer between layers (a) and (b), which intermediate layer comprises a mixture of

($c_1$) at least one polymeric binder which is compatible with the polymeric binder ($a_1$) of the layer (a), and

($c_2$) at least one photopolymerizable ethylenically unsaturated monomer compatible with ($c_1$), wherein the intermediate layer contains a monomer ($c_2$) of the formula

$$\begin{array}{l} CH_2{=}CR^1{-}COO\,(CH_2{-}CHR^3{-}O{-})_m{-}CO{-}NH \\ \qquad\qquad\qquad\qquad\qquad\qquad\quad | \\ \qquad\qquad\qquad\qquad\qquad\qquad\quad X \\ \qquad\qquad\qquad\qquad\qquad\qquad\quad | \\ CH_2{=}CR^2{-}COO\,(CH_2{-}CHR^4{-}O{-})_n{-}CO{-}NH \end{array}$$

where

$R^1$, $R^2$, $R^3$ and $R^4$ may be identical or different and each is H or $C_1$-$C_8$-alkyl,

X is $C_2$-$C_7$-alkylene, an aromatic $C_6$-$C_{10}$-hydrocarbon radical or isophoronylene, and

m and n are each integers from 1 to 4 and may be identical or different, and the intermediate layer, after its application to the base, has been dried at from 110° to 220 °C.

2. A laminate as claimed in claim 1, wherein the monomer ($c_2$) is a reaction product of 2 moles of β-hydroxyethyl acrylate or methacrylate or β-hydroxypropyl acrylate or methacrylate with 1 mole of hexamethylene diisocyanate, toluylene diisocyanate or isophorone diisocyanate.

3. A laminate as claimed in claim 1 or 2, wherein the intermediate layer (c) contains from 1 to 25 % by weight of the monomer ($c_2$), based on the mixture of ($c_1$) and ($c_2$).

4. A laminate as claimed in claims 1 to 3, wherein the intermediate layer (c) contains a water-soluble vinyl alcohol polymer as the polymeric binder ($c_1$).

5. A laminate as claimed in any of claims 1 to 4, wherein the intermediate layer (c) contains a mixture of from 75 to 99 % by weight of a water-soluble vinyl alcohol polymer as the polymeric binder ($c_1$), and from 1 to 25 % by weight of the monomer ($c_2$).

6. A laminate as claimed in any of claims 1 to 5, wherein the base (b) is a metal support which has been pretreated mechanically or chemically and/or provided with an adhesive layer.

## Revendications

1. Eléments multicouches appropriés pour la fabrication de formes d'impression et formes en relief, comprenant :

a) une couche photosensible d'un mélange, soluble dans l'eau ou dans une solution aqueuse, de

a1) au moins un liant polymère hydrophile

a2) au moins un monomère à insaturation éthylénique, photopolymérisable et compatible avec le précédent,

a3) un photo-initiateur activable à la lumière actinique

b) une couche support de dimensions stables, et

c) une couche intermédiaire mince, entre la couche a) et la couche b), d'un mélange de

c1) au moins un liant compatible avec le liant polymère (a1) de la couche a) et

c2) au moins un monomère à insaturation éthylénique, photopolymérisable, compatible avec le précédent,

caractérisés par le fait que la couche intermédiaire contient un monomère (c2') de structure :

$$\begin{array}{l} CH_2{=}CR^1{-}COO({-}CH_2{-}CHR^3{-}O)_m{-}CO{-}NH \\ \qquad\qquad\qquad\qquad\qquad\qquad\qquad\quad\;\; X \\ CH_2{=}CR^2{-}COO({-}CH_2{-}CHR^4{-}O)_n{-}CO{-}NH \end{array}$$

dans laquelle

$R^1$, $R^2$, $R^3$, $R^4$ représentent H ou un reste alkyle en $C_1$-$C_8$, identiques ou différents

X = reste alkylène en $C_2$-$C_7$, reste d'hydrocarbure aromatique en $C_6$-$C_{10}$ ou reste isophoronylène.

n, m = 1 à 4, identiques ou différents, et la couche intermédiaire, après dépôt sur la couche support, est séchée à une température de 110 à 220 °C.

2. Eléments multicouches selon la revendication 1, caractérisés par le fait que le monomère (c2') représente un produit de réaction de 2 moles de β-hydroxyéthyl- ou β-hydroxypropylacrylate ou -méthacrylate et 1 mole d'hexaméthylendiisocyanate, toluylendiisocyanate ou isophorondiisocyanate.

3. Eléments multicouches selon la revendication 1 ou 2, caractérisés par le fait que la couche intermédiaire possède le monomère (c2') en proportions de 1 à 25 % en poids du mélange de (c1) et (c2).

4. Eléments multicouches selon les revendications 1 à 3, caractérisés par le fait que la couche intermédiaire (c) contient, comme liant polymère (c1), un polymère d'alcool vinylique, soluble dans l'eau.

5. Eléments multicouches selon l'une des revendications 1 à 4, caractérisés par le fait que la couche intermédiaire (c) contient un mélange de 75 à 99 % en poids d'un polymère d'alcool vinylique soluble dans l'eau, comme liant polymère (c1), et à 1 à 25 % en poids du monomère (c2').

6. Eléments multicouches selon l'une des revendications 1 à 5, caractérisés par le fait que la couche support (b) est constituée par une sous-couche métallique, prétraitée mécaniquement, chimiquement et/ou par garnissage avec une couche de fond d'adhérence.